# EUROPEAN PATENT SPECIFICATION

(11) **EP 3 650 870 B1**
(45) Date of publication and mention of the grant of the patent: **22.09.2021**
(21) Application number: 19206937.5
(22) Date of filing: 04.11.2019
(51) Int. Cl.: G01R 22/06, H01Q 1/22, G01R 11/04

(54) **ELECTRICITY METER WITH ANTENNA ISOLATION BOARD**
ELEKTRIZITÄTSZÄHLER MIT ANTENNENISOLATIONSPLATTE
COMPTEUR D'ÉLECTRICITÉ COMPORTANT UN PANNEAU D'ISOLATION D'ANTENNE

(30) Priority: 07.11.2018 EP 18204895
(43) Date of publication of application: 13.05.2020
(73) Proprietor: Kamstrup A/S, 8660 Skanderborg (DK)
(72) Inventor: Hansen, Jan Tejlgaard, DK-8660 Skanderborg (DK); Risom, Jens Belger, DK-8660 Skanderborg (DK)
(74) Representative: Plougmann Vingtoft a/s

(56) References cited:
- WO-A1-2018/142995
- CN-U- 202 694 552
- US-A1- 2011 175 749
- US-A1- 2015 280 308

## Description

### FIELD OF THE INVENTION

The present invention relates to the field of electricity meters including wireless communication means being arranged for connection of external antenna elements.

### BACKGROUND OF THE INVENTION

The evolution from mechanical electricity meters to the first generations of electronic meters and further on to the smart meters of today has caused significant reduction in: the life time; acceptable price of manufacturing; installation cost of the meters. The smart electricity meters are typically replaced after 10 - 15 years of operation and may be upgraded with new and improved communication technologies during the life time. Thus, price reduction of the meter as well as installation and maintenance costs has become increasingly important. All elements of the electricity meter must thus be optimized.

Smart electricity meters often include wireless radio communication means for remote reading of consumption data. Such meters usually have a built-in antenna arranged inside the meter casing. However, due to some meters being installed in location impeding wireless communication, such as metal cabinets or basements, external antennas may be required to establish a reliable wireless communication link. Some meter also include wired communication means.

Connecting an external communication connection or an external antenna to the communication module of an electricity meter requires the external communication means to be isolated from circuits of the meter subject to grid voltage. In smart electricity meters, the communication module, such as a transceiver and radio circuit, and the meter measurement circuit are often powered by and thus connected with the one or more phases and neutral through which power is delivered to the consumption site. Therefore, the external antenna or other external communication equipment must be isolated from the communication module to prevent users touching the antenna, from being exposed to the high voltages of the grid.

US 2011/175749 A1 discloses an electricity meter reading device comprising a transceiver connected to the metering circuit, and an antenna coupled to the transceiver via an antenna isolation circuit to emit the generated signal.

However, as a need exists to optimize meters and only a fraction of meters requires an external antenna, implementing high voltage isolation for external antennas and/or other external equipment is not required for all meters. Since electricity meter are produced in high volume cost optimization is essential. Further, it may not be possible to determine whether an external antenna is required until after a meter has been installed and connected to the power lines, whereby it becomes subject to grid voltage.

A need exists for smart electricity meters wherein external antennas or other communication equipment as well as associated isolation can be connected to the meter after installation. Especially the possibility to retrofit an external antenna including antenna isolation in a installed electricity meter already connected to grid voltage in a safe way without risking personal damage by contact to grid voltage is desired.

### OBJECT OF THE INVENTION

An object of the present invention is to provide an alternative to the prior art.
In particular, it may be seen as a further object of the present invention to provide an electricity meter, adapted for retrofitting of an external antenna, that solves the above mentioned problems of the prior art with

### SUMMARY OF THE INVENTION

Thus, the above described object and several other objects are intended to be obtained in a first aspect of the invention by providing an electricity meter adapted for retrofitting of an external antenna and associated antenna isolation comprising: a measurement circuit; a radio circuit connected with one or more phases, whereby it is subject to grid voltage; a connector on a main board for engaging an external antenna connection; a meter housing arranged to enclose the measurement circuit and the radio circuit; and an antenna isolation board arranged to be connected to the main board, the antenna isolation board comprising: a main board connector for engaging the connector on the main board; an antenna connector for connecting the antenna isolation board to an antenna cable; and an isolation circuit providing an antenna signal path and a galvanic isolation barrier between the main board connector and the antenna connector, characterized in that: the meter housing comprises a slot arranged to allow retrofitting the antenna isolation board; slot is open towards the main board of the electricity meter; and the main board connector on the antenna isolation board is arranged to engage with the connector on the main board, when the antenna isolation board is inserted into the slot.

Retrofitting an external antenna and associated galvanic isolation has the advantage the only meters which are installed on sites requiring external antenna installation will have the cost of the galvanic isolation and external antenna. The majority of installed meters will need only an internal antenna which do not need to be isolated from the grid voltage. The meter housing encloses the measurement circuit and radio circuit which means that persons are protected from the grid voltage. Connecting an external antenna to the radio circuit requires a galvanic isolation to prevent electrical chock and personal damage. The meter housing provides a slot through which the antenna isolation board is connected to the radio circuit. The slot has the effect that the risk of unintentional contact with elements subject to grid voltage is reduced. The connector on the main board and the main board connector on the isolation board may be any suitable connector allowing easy installation of the antenna isolation board without the use of tools or touching the connector on the main board. The connector may be an RF connector such as an MCX connector or a general connector such as a pin header. The isolation circuit isolates the antenna connector from the grid voltage and prevents electrical chock. By the main board connector on the antenna isolation board being arranged to engage with the connector on the main board, when the antenna isolation board is inserted into the slot is to be understood the connectors automatically engages and create a connection when the antenna isolation board is inserted in the slot. This has the effect that the antenna isolation board may be retrofitted without touching any part of the electricity meter subject to grid voltage. Thus the external antenna and antenna isolation board may be installed / retrofitted by persons not skilled or authorized for working with elements subject to high voltage or grid voltage. This has the advantage that an external antenna connection may be retrofitted at a lower cost.

To prevent electrical chock when installing the antenna isolation board the electricity meter may designed such that the slot has a form factor which prevents unintentional access to the mainboard. Especially the slot may be designed as a narrow passage allowing only a narrow object such as the antenna isolation board to be inserted.

The slot may provide a sleeve for receiving the antenna isolation board and an access opening to the main board arranged to allow the main board connector on the antenna isolation board to engage with the connector on the main board. The access opening has the advantage of limiting the open area in the bottom of the slot, whereby the installation of the antenna isolation board is assisted. The slot may be arranged to have an open part of the slot bottom which communicates with the connector on the main board. Arranging the access opening or the open part at the bottom of the slot has the advantage that of restricting access and preventing unintentional access to the main board of the meter or any other part of the meter subject to grid voltage.

The antenna cable may be connected to the antenna isolation board via a coaxial connector. This has the advantage that the antenna cable may easily be detached form the antenna isolation board to be fed through a small hole e.g. in a wall, which will reduce the installation cost. Different types of coaxial connectors may be used, such as SMX, MCX or other suitable types.

Alternatively the antenna cable may be directly connected to the antenna isolation board. A direct connection has the advantage of not requiring any RF connectors which will ad cost to the product. The antenna cable may be connected to the antenna isolation board by soldering or by use of screw terminals.

The antenna isolation board may be a multi-layered Printed Circuit Board (PCB) and the isolation circuit include two plate capacitors implemented using layers of the antenna isolation board. Using the layers of the PCB for implementing capacitors has the advantage of cost reduction. Especially if the two plate capacitors are implemented using inner layers of the antenna isolation board there will be no risk of electrical chock when inserting the antenna isolation board to the slot of the electricity meter in that the surface of the antenna isolation board is isolated by the PCB dielectric layers in that the plate capacitors are not implemented on neither the top nor the bottom layer of the PCB.

The measurement circuit of the electricity meter is arranged to measure the amount of energy delivered to a consumption site. At least parts of the measurements circuit is thus subject to grid voltage. The radio circuit may indirectly be subject to grid voltage due to the power supply for the radio circuit does not provide sufficient isolation for the radio circuit to be touch safe or due to creepage and/or clearance distances internal in the meter not being sufficient. This means that even though the radio circuit is galvanic isolated from the grid voltage or phases this isolation may not be sufficient to make it touch safe. The radio circuit being connected to one or more phases and thus being subject to grid voltage shall be understood as the radio circuit not being isolated sufficiently from the grid voltage to be touch safe. Being "connected to" shall in this context not be interpreted as "galvanic connected to".

The main board may comprise more than one board, such as PCB boards. The main board is to be understood as a board or collection of boards in the electricity meter which are subject to grid voltage, whereby touching them would include a risk of electrical chock and injury.

### BRIEF DESCRIPTION OF THE FIGURES

The figures show one way of implementing the present invention and is not to be construed as being limiting to other possible embodiments falling within the scope of the attached claim set.
Figure 1 shows a smart electricity meter adapted for retrofitting of an external antenna and associated antenna isolation,
Figures 2a and 2b illustrate how an antenna isolation board may be inserted into a slot in the meter casing to be connected to the main board of the electricity meter,
Figures 3a and 3b illustrate how an antenna isolation board may be inserted into a slot in the meter casing to be connected to the main board of the electricity meter,
Figure 4 shows the slot in the meter casing from the rear side of the casing cover,
Figure 5 shows the smart electricity meter with the casing cover removed and the antenna isolation board connected to the main board,
Figure 6a-6c show the antenna isolation board and associated antenna cable,
Figure 7 is a see-through illustration of the antenna isolation board, and
Figure 8 is an electrical diagram of an embodiment of an antenna isolation circuit for implementation on the antenna isolation board.

### DETAILED DESCRIPTION OF AN EMBODIMENT

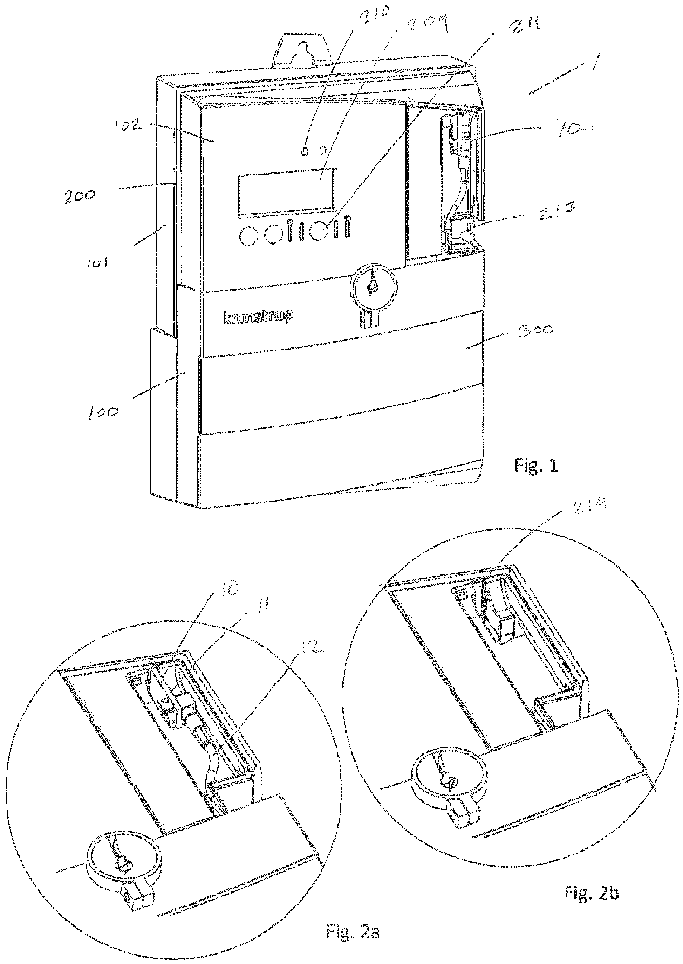

Figure 1 shows a smart electronic electricity meter 100 adapted for retrofitting of an external antenna and associated antenna isolation. The electricity meter includes a casing comprises a casing base 101, a casing cover 102 and a terminal cover 300. The casing base and casing cover together constitute a meter housing 200 wherein the electronic parts of the meter, such as the measurement circuit, the communication module and radio circuit, are enclosed. Additional elements such as breakers for disconnecting the consumption site, input terminals for sub meters, etc. may also be arranged inside the meter housing. Terminals for connection of power lines to the meter are arranged underneath the terminal cover. The terminal cover 300 is mounted on the meter housing 200 to create a complete meter casing 100. The terminal cover shields the terminals 201 and other interfaces from unauthorized access to avoid risk of unintended contact to the terminals and fraudulent modifications of the installation.

The casing cover 102 is made from polymer and provided with an interfacing surface suitable for ultrasonic welding to the casing base 101. The casing cover has a display opening 209, an infrared communication port opening 211 and light emission openings 210 which all may be covered by a light transparent element (not shown). Holes for buttons are provided to enable user interaction with the meter inside the meter casing. Further holes for various connectors are provided in the casing cover, such as a RJ45 connector 213, input terminals and an external antenna connection 10. Some connectors are covered by various covers or lids after installation, while others are directly accessible. Finally holes for operating the terminals are provided to connect the meter to the power lines of the utility distribution network and the consumption site. When the connectors, buttons and transparent elements are mounted the internal of the meter housing is inaccessible through the openings in the casing cover.

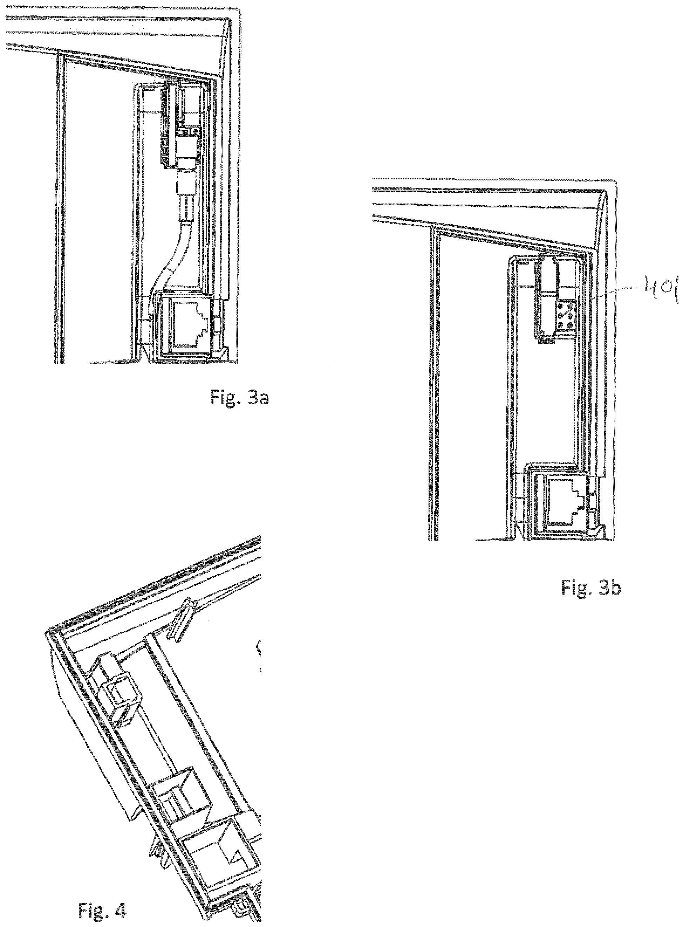

Referring to Fig. 2a and 2b the upper right corner of the smart electronic electricity meter 100 is shown. The figures illustrate the external antenna connection 10 comprising an antenna isolation board 11 inserted into a slot 214 provided in the casing cover 102. Through the slot 214, the antenna isolation board is connected to the main board 400 of the electricity meter as shown in Fig. 4. The form factor of the slot prevents unauthorised or unintentional access to the main board, which could result in meter damage or danger due to the main board being subject to grid voltage. The slot is designed as a narrow passage allowing only a narrow object such as the antenna to be inserted. As shown in Fig. 2a, the antenna connection, including the antennas isolation board 11 and antenna cable 12, is arranged in an indentation of the casing cover. Thereby, after installation the antenna connection may be cover by a lid (not shown) mounted on the casing cover.

Fig. 3a and 3b also illustrates the slot in the meter casing with and without the antenna connection. As seen from Fig. 3b and Fig. 4, only part of the bottom of the slot is open towards the main board of the electricity meter. The open part of the slot bottom communicates with a connector 401, such as a plug or socket, provided on the main board. The slot provides a sleeve for receiving the antenna isolation board and an access opening to the main board 400. The slot may be arranged in the casing cover or in the casing base or another part of the casing provided that the slot provides an opening towards the main board and the opening communicates with the connector on the main board 401. In this way the slot provides access to the connector on the main board to enable the antenna isolation board to engage with the main board in that the connector on the main board and the main board connector on the antenna isolation board are connected when the antenna isolation board is inserted to the slot.

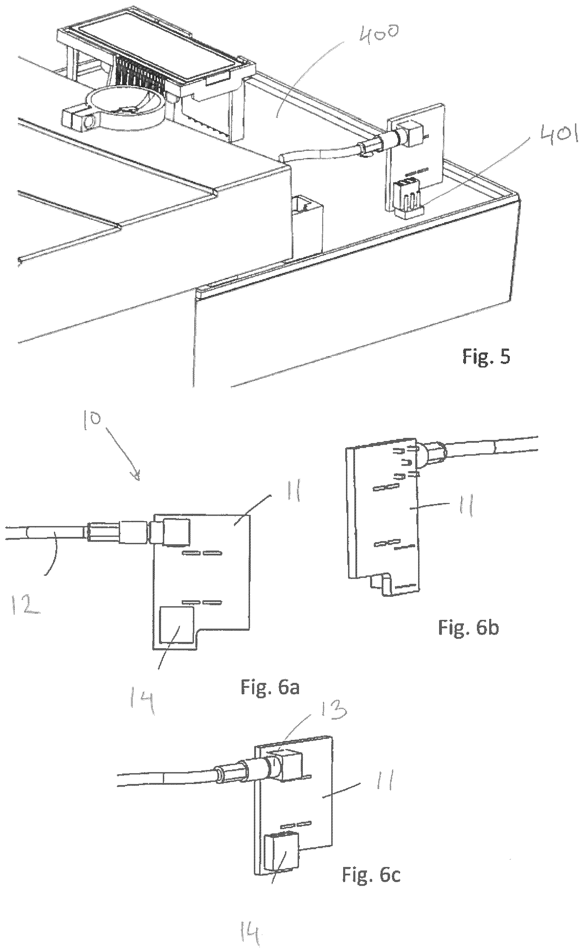

Referring to Fig. 6a-6c, the antenna connection comprises the antenna isolation board and an antenna cable 12. The antenna cable is shown to be connected to the board via a coaxial connector 13, however various other antenna connectors may also be used. By including an antenna connector for the antenna cable, the antenna cable may be disconnected from the isolation board or mounted to the isolation board after installation of the external antenna and antenna cable. Removing the antenna cable from the isolation board may be advantageous if the cable must be taken through narrow openings or installation holes during installation of the external antenna. In other embodiments, the antenna cable may also be directly connected to the antenna isolation board.

The antenna connection further comprises a connector 14 for engaging the connector 401 on the main board. The main board connector 14 is mounted on the antenna isolation board and arranged to engage with the connector 401 mounted on the main board, when the isolation board is inserted into the slot in the casing cover. Engaging the main board connector and the connector on the main board does not require manipulation of the connector or any form of contact with the connectors. The main board connector and the connector on the main board engages automatically when the isolation board is inserted to the slot. Connectors not requiring the use of tools or fingers for engaging are in example a MCX connector or a general connector such as a pin header.

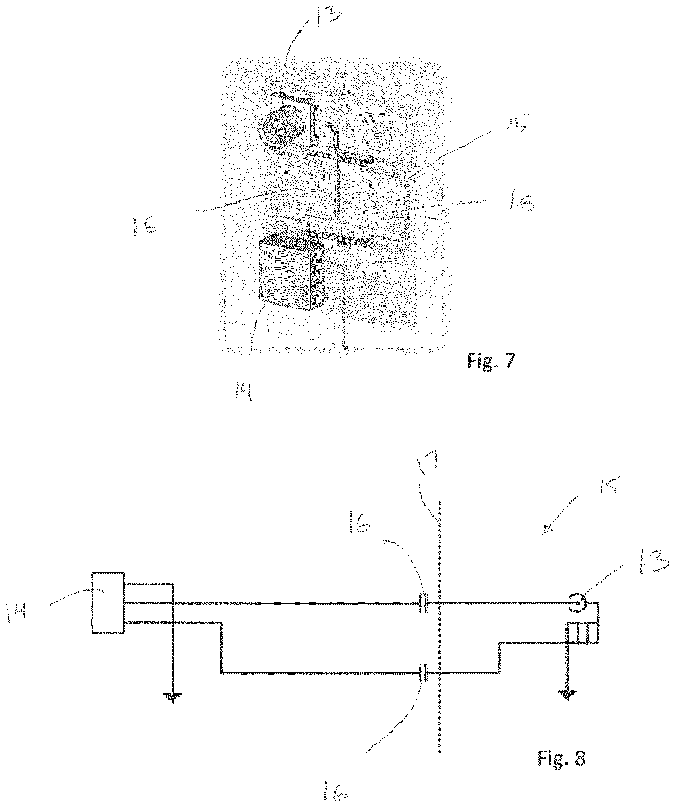

The antenna isolation board is a multilayered printed circuit board (PCB). On the antenna isolation board an isolation circuit 15 is implemented as show in fig. 7 and illustrated by the diagram in Fig. 8. The isolation circuit serves to provide an antenna signal path and galvanically isolate the connector 14 for engaging the main board and the connector 13 for being coupled to antenna cable. The main galvanic isolation is achieved by the isolation circuit including two plate capacitors 16 in the antenna signal path. The plate capacitors are implemented using layers of the isolation board. In one embodiment the isolation board is a six layer PCB and the plate capacitors are implemented using the inner layers 2 thru 5. In this embodiment the outer layers are not used for the plate capacitors isolate plate capacitor and protect users during installation of the external antenna. The laminate material of the PCB includes 35%-50% resin, such as approximately 45% resin and the laminate material has an electrical strength of 25-35 kV/mm, such as 30 kV/mm. Further, the layer thickness of the dielectric material of the PCB is chosen to be from 0.20-0.24 mm, such as 0.22 mm, whereby a sufficient electrical strength of the material may be achieved, and present insulation standards may be fulfilled.

In Fig. 7 the isolation board is shown to include a straight coaxial connector however an angled connector may also be used as shown in the remaining figures.

The dotted line 17 in Fig. 8 illustrates the galvanic isolation barrier between the connector 14 for engaging the main board and the connector 13 for being coupled to antenna cable. The part of the circuit to the left of the isolation barrier is connected to the hazardous mains potential of the main board. The other half to the right of the isolation barrier is connected to the antenna cable and galvanically isolated.

Although the present invention has been described in connection with the specified embodiments, it should not be construed as being in any way limited to the presented examples. The scope of the present invention is set out by the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention.

## Claims

1. An electricity meter adapted for retrofitting of an external antenna and associated antenna isolation comprising:
- a measurement circuit;
- a radio circuit connected with one or more phases, whereby it is subject to grid voltage;
- a connector (401) on a main board for engaging an external antenna connection;
- a meter housing arranged to enclose the measurement circuit and the radio circuit; and
- an antenna isolation board (11) arranged to be connected to the main board (400), the antenna isolation board comprising:
- a main board connector (14) for engaging the connector (401) on the main board;
- an antenna connector (13) for connecting the antenna isolation board to an antenna cable; and
- an isolation circuit providing an antenna signal path and a galvanic isolation barrier between the main board connector (14) and the antenna connector (13), **characterized in that**:
- the meter housing comprises a slot (214) arranged to allow retrofitting the antenna isolation board;
- the slot is open towards the main board of the electricity meter; and
- the main board connector (14) on the antenna isolation board (11) is arranged to engage with the connector (401) on the main board, when the antenna isolation board is inserted into the slot (214).

2. The electricity meter according to claim 1, wherein the slot has a form factor which prevents unintentional access to the mainboard.

3. The electricity meter according to any of the preceding claims, wherein the slot (214) is a narrow passage allowing only a narrow object such as the antenna isolation board (11) to be inserted.

4. The electricity meter according to any of the preceding claims, wherein the slot (214) provides a sleeve for receiving the antenna isolation board (11) and an access opening to the main board (400) arranged to allow the main board connector (14) on the antenna isolation board (11) to engage with the connector (401) on the main board.

5. The electricity meter according to any of the preceding claims, wherein the slot (214) has a open part of the slot bottom which communicates with the connector (401) on the main board

6. The electricity meter according to any of the preceding claims, wherein the antenna cable is connected to the antenna isolation board via a coaxial connector.

7. The electricity meter according to any of the preceding claims, wherein the antenna cable is directly connected to the antenna isolation board.

8. The electricity meter according to any of the preceding claims wherein the antenna isolation board is a multi-layered Printed Circuit Board and the isolation circuit include two plate capacitors implemented using layers of the antenna isolation board.

9. The electricity meter of claim 5, wherein the two plate capacitors are implemented using inner layers of the antenna isolation board.

10. The electricity meter according to any of the preceding claims, wherein the slot is arranged in the casing cover.

## Patentansprüche

1. Elektrizitätszähler, der zum Nachrüsten einer externen Antenne und zugehöriger Antennenisolierung angepasst ist, umfassend:
- eine Messschaltung;
- eine Funkschaltung, die mit einer oder mehreren Phasen verbunden ist, wodurch sie Gitterspannung ausgesetzt ist;
- einen Steckverbinder (401) an einer Hauptplatine zum Herstellen einer Verbindung mit einer externen Antenne;
- ein Zählergehäuse, da so angeordnet ist, dass es die Messschaltung und die Funkschaltung umschließt; und
- einen Antennenisolationsplatte (11), die dazu angeordnet ist, mit der Hauptplatine (400) verbunden zu sein,
wobei die Antennenisolationsplatte Folgendes umfasst:
- einen Hauptplatinensteckverbinder (14) zum Herstellen der Verbindung mit dem Steckverbinder (401) an der Hauptplatine;
- einen Antennensteckverbinder (13) zum Verbinden der Antennenisolationsplatte mit einem Antennenkabel; und
- eine Isolationsschaltung, die einen Antennensignalweg und eine galvanische Isolationsbarriere zwischen dem Hauptplatinensteckverbinder (14) und dem Antennensteckverbinder (13) bereitstellt,
**dadurch gekennzeichnet, dass**:
- das Zählergehäuse einen Steckplatz (214) umfasst, der dazu angeordnet ist, ein Nachrüsten der Antennenisolationsplatte zu ermöglichen;
- der Steckplatz in Richtung der Hauptplatine des Elektrizitätszählers offen ist; und
- der Hauptplatinensteckverbinder (14) an der Antennenisolationsplatte (11) dazu angeordnet ist, eine Verbindung mit dem Steckverbinder (401) an der Hauptplatine herzustellen, wenn die Antennenisolationsplatte in den Steckplatz (214) eingesetzt ist.

2. Elektrizitätszähler nach Anspruch 1, wobei der Steckplatz einen Formfaktor aufweist, der unbeabsichtigten Zugriff auf die Hauptplatine verhindert.

3. Elektrizitätszähler nach einem der vorhergehenden Ansprüche, wobei der Steckplatz (214) ein schmaler Durchgang ist, der es nur einem schmalen Objekt wie etwa der Antennenisolationsplatte (11) ermöglicht eingesetzt zu werden.

4. Elektrizitätszähler nach einem der vorhergehenden Ansprüche, wobei der Steckplatz (214) eine Hülle zum Aufnehmen der Antennenisolationsplatte (11) und eine Zugriffsöffnung zu der Hauptplatine (400), die so angeordnet ist, dass es dem Hauptplatinensteckverbinder (14) an der Antennenisolationsplatte (11) ermöglicht wird, eine Verbindung mit dem Steckverbinder (401) an der Hauptplatine herzustellen, bereitstellt.

5. Elektrizitätszähler nach einem der vorhergehenden Ansprüche, wobei der Steckplatz (214) einen offenen Teil am Steckplatzboden aufweist, der mit dem Steckverbinder (401) an der Hauptplatine korrespondiert.

6. Elektrizitätszähler nach einem der vorhergehenden Ansprüche, wobei das Antennenkabel über einen koaxialen Steckverbinder mit der Antennenisolationsplatte verbunden ist.

7. Elektrizitätszähler nach einem der vorhergehenden Ansprüche, wobei das Antennenkabel direkt mit der Antennenisolationsplatte verbunden ist.

8. Elektrizitätszähler nach einem der vorhergehenden Ansprüche, wobei die Antennenisolationsplatte eine mehrschichtige Leiterplatte ist und die Isolationsschaltung zwei Plattenkondensatoren beinhaltet, die unter Verwendung von Schichten der Antennenisolationsplatte umgesetzt sind.

9. Elektrizitätszähler nach Anspruch 5, wobei die zwei Plattenkondensatoren unter Verwendung von inneren Schichten der Antennenisolationsplatte umgesetzt sind.

10. Elektrizitätszähler nach einem der vorhergehenden Ansprüche, wobei der Steckplatz in der Umhüllungsabdeckung angeordnet ist.

## Revendications

1. Compteur d'électricité adapté pour l'installation ultérieure d'une antenne externe et d'une isolation d'antenne associée comprenant :
- un circuit de mesure ;
- un circuit radio connecté à une ou plusieurs phases, moyennant quoi il est soumis à la tension du réseau ;
- un connecteur (401) sur une carte mère pour se mettre en prise avec une connexion d'antenne externe ;
- un boîtier de compteur agencé pour enfermer le circuit de mesure et le circuit radio ; et
- une carte d'isolation d'antenne (11) agencée pour être connectée à la carte mère (400),
la carte d'isolation d'antenne comprenant :
- un connecteur de carte mère (14) pour se mettre en prise avec le connecteur (401) sur la carte mère ;
- un connecteur d'antenne (13) pour connecter la carte d'isolation d'antenne à un câble d'antenne ; et
- un circuit d'isolation fournissant un chemin de signal d'antenne et une barrière d'isolation galvanique entre le connecteur de carte mère (14) et le connecteur d'antenne (13),
**caractérisé en ce que** :
- le boîtier du compteur comprend une fente (214) agencée pour permettre l'installation ultérieure de la carte d'isolation d'antenne ;
- la fente est ouverte vers la carte mère du compteur électrique ; et
- le connecteur de carte mère (14) sur la carte d'isolation d'antenne (11) est agencé pour se mettre en prise avec le connecteur (401) sur la carte mère, lorsque la carte d'isolation d'antenne est insérée dans la fente (214).

2. Compteur d'électricité selon la revendication 1, ladite fente possédant un facteur de forme qui empêche l'accès involontaire à la carte mère.

3. Compteur d'électricité selon l'une quelconque des revendications précédentes, ladite fente (214) étant un passage étroit permettant uniquement à un objet étroit tel que la carte d'isolation d'antenne (11) d'être inséré.

4. Compteur d'électricité selon l'une quelconque des revendications précédentes, ladite fente (214) fournissant un manchon pour recevoir la carte d'isolation d'antenne (11) et une ouverture d'accès à la carte mère (400) agencée pour permettre au connecteur de carte mère (14) sur la carte d'isolation d'antenne (11) de se mettre en prise avec le connecteur (401) sur la carte mère.

5. Compteur d'électricité selon l'une quelconque des revendications précédentes, ladite fente (214) possédant une partie ouverte de la partie inférieure de fente qui communique avec le connecteur (401) sur la carte mère.

6. Compteur d'électricité selon l'une quelconque des revendications précédentes, ledit câble d'antenne étant connecté à la carte d'isolation d'antenne par l'intermédiaire d'un connecteur coaxial.

7. Compteur d'électricité selon l'une quelconque des revendications précédentes, ledit câble d'antenne étant directement connecté à la carte d'isolation d'antenne.

8. Compteur d'électricité selon l'une quelconque des revendications précédentes, ladite carte d'isolation d'antenne étant une carte de circuit imprimé multicouche et ledit circuit d'isolation comprenant deux condensateurs à plaques mis en oeuvre à l'aide des couches de la carte d'isolation d'antenne.

9. Compteur d'électricité selon la revendication 5, lesdits deux condensateurs à plaques étant mis en oeuvre à l'aide des couches internes de la carte d'isolation d'antenne.

10. Compteur d'électricité selon l'une quelconque des revendications précédentes, ladite fente étant agencée dans le couvercle de boîtier.
